# EUROPEAN PATENT SPECIFICATION

(11) **EP 0 624 274 B1**
(45) Date of publication and mention of the grant of the patent: **15.04.1998**
(21) Application number: 93902465.9
(22) Date of filing: 27.01.1993
(51) Int. Cl.: G10K 11/16

(54) **ACTIVE NOISE CANCELLATION**
AKTIVE RAUSCHUNTERDRÜCKUNG
SUPPRESSION ACTIVE DE BRUIT

(30) Priority: 28.01.1992 GB 9201761
(43) Date of publication of application: 17.11.1994
(73) Proprietor: NOISE CANCELLATION TECHNOLOGIES, INC., Stamford, CT 06901 (US)
(72) Inventor: CURTIS, Alan, Robert, Douglas, Phoenix, AZ 85044 (US)
(74) Representative: Read, Matthew Charles
(86) International application number: GB9300169
(87) International publication number: WO9315501

(56) References cited:
- GB-A- 2 097 629
- GB-A- 2 154 830

## Description

### FIELD OF THE INVENTION

This invention relates to an apparatus for and a method of cancelling phenomena such as noise.

### BACKGROUND TO THE INVENTION

Hitherto, it has been appreciated that noise, for example, from an engine, has a repetitive characteristic which is a function of engine speed. Prior active cancellation proposals have utilised a reference signal based upon engine speed to generate a secondary signal which can be used to cancel the primary engine noise. In a so-called filtered-X system, a reference signal x having a frequency corresponding to engine speed, is filtered using an adaptive filter to produce the secondary, cancelling signal. The adaptive filter essentially comprises a series of delay elements each with an individual weighting, having their outputs connected together to form a transversal filter, the weighting characteristics of each delay element being adjustable by the use of a least mean squares algorithm, (LMS), for example as disclosed by B. Widrow and S.D. Stearns in "Adaptive Signal Processing" Prentice Hall 1985. The LMS algorithm is performed in accordance with the value of an error signal detected by a microphone, representative of the residual occurring after cancellation of the primary by the secondary signal. The secondary signal is typically produced by a loudspeaker or actuator connected to the output of the adaptive filter.

This prior system tended to be unstable since there was no compensation for the transfer function presented to the secondary signal between the actuator and the error detecting microphone. In order to overcome the problem, a so-called modelling filter has been included in the input to the adaptive control filter in order to improve stability.

A problem with the prior filtered-X system is that it assumes that the transfer function between the actuator and error sensing microphone is constant in all circumstances. In practice, the transfer function may vary for example as a function of engine speed or some other operating condition. As a result, the filter characteristics for the model filter may not accurately reflect the actual transfer function and consequently, system instabilities can arise.

### SUMMARY OF THE INVENTION

With a view to overcoming this problem the present invention provides in a first aspect, apparatus for cancelling primary phenomena, such as noise, that are generally synchronous with a cyclic reference signal, comprising: control filter means for adaptively filtering the reference signal to produce a secondary signal; actuator means responsive to the secondary signal to produce secondary phenomena for cancelling the primary phenomena; error signal detecting means for detecting the residual of the primary and secondary phenomena; model filter means for filtering the reference signal and having a filtering characteristic selected in dependence upon the transfer function for said secondary phenomena from the actuator means through the detecting means, whereby to provide a filtered reference signal, the model filter means having its filtering characteristics selectible in dependence upon an operating condition; means responsive to said filtered reference signal and said detected residual for adaptively controlling said control filter means so as to tend to minimise said residual; sensor means for sensing said operating condition; and selecting means for selecting the filtering characteristic of the model filter means in dependence upon the sensed operating condition.

In accordance with the invention from a second aspect there is provided a method of cancelling primary phenomena, such as noise, that are generally synchronous with a cyclic reference signal, comprising: adaptively filtering the reference signal with a control filter to produce a secondary signal; producing secondary phenomena for cancellling the primary phenomena in response to the secondary signal; detecting the residual of the primary and secondary phenomena; filtering the reference signal with a model filter having a filtering characteristic selected in dependence upon the transfer function for the secondary phenomena whereby to provide a filtered reference signal; adaptively controlling the control filter so as to tend to miminise the residual, in response to the detected residual and the filtered reference signal; sensing an operating condition; and selecting the filtering characteristic of the model filter in dependence upon the sensed operating condition.

Since the model filter according to the invention has a filtering characteristic selected according to the operating condition, e.g. the frequency of the cyclic reference signal, apparatus according to the invention is less prone to system instabilities than prior filtered-X systems and can adapt in a more stable manner to rapid changes in reference signal frequency.

### BRIEF DESCRIPTION OF THE DRAWINGS

In order that the invention may be more fully understood, an embodiment thereof will now be described by way of example with reference to the accompanying drawings in which:
Figure 1 is a schematic block diagram of a prior art filtered-X system;
Figure 2 is a schematic block flow diagram of the prior art filtered-X system shown in Figure 1;
Figure 3 is a schematic block diagram of an example of apparatus in accordance with the invention; and
Figure 4 is a schematic diagram corresponding to Figure 2, illustrating operation of the apparatus according to the invention shown in Figure 3.

### DESCRIPTION OF EMBODIMENTS

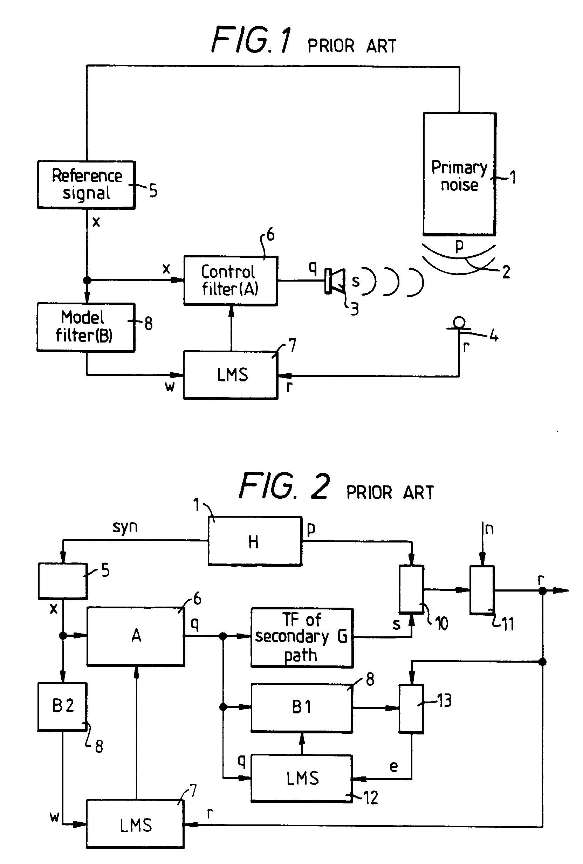

Referring firstly to Figures 1 and 2, an active noise cancellation system is shown, typically for an internal combustion engine. The engine is shown as a primary noise source 1, which radiates primary noise 2. In order to cancel the primary noise, the system also generates secondary noise from an actuator 3, typically a loudspeaker. The primary and secondary noise combine so as to produce a substantial cancellation of the primary noise. However, in practice, low level residual noise occurs, which is sensed by an error detection microphone 4.

In a filtered-X system it has been appreciated that the primary noise has characteristics dependent upon engine speed. A suitable secondary signal is produced by adaptively filtering a reference signal x dependent upon engine speed. The reference signal x is typically a sine wave produced from the output of a tachometer connected to the engine and is shown schematically as block 5 in Figure 1. The output of the reference signal generator 5 is fed to an adaptive transversal filter, known as the control or A filter 6, which provides an output to the actuator 3. The filter can be considered as a chain of delay elements each with an individual adjustable weighting, with the outputs of the delay elements being connected together in a summing junction. The values of the individual weights are selectively adjustable under the control of an LMS algorithm 7.

The algorithm controller 7 operates in response to the error signal detected by the microphone 4 in order to minimise the error signal. In order to reduce system instabilities, the system also supplies to the algorithm controller 7 a filtered version w of the signal x produced by a model filter 8, which has filtering characteristics selected to model the transfer function for the secondary signal between the actuator 3 and the error detection microphone 4. The provision of the model filter 8, also known as the B filter, allows the system to model more closely the actual system by accounting for the dynamics of the filter 6, the delay time between the actuator 3 and the microphone 4, and the dynamics of the error microphone 4.

Referring to Figure 2, this shows the system of Figure 1 in a more functional block diagrammatic form.

The primary noise source 1 is labelled block H which produces primary noise p and a synchronisation signal syn that is fed to reference signal generator 5 in order to produce the reference signal x. The model filter 8 during set-up is connected in position B1 whereas during normal operation, it is connected in position B2. The control filter 6 has its filter weights adjusted by LMS algorithm controller 7, so as to filter the reference signal x and produce a signal q. The transfer function of the actuator 3 and the microphone 4 is graphically represented by block G, which results in a secondary signal s that is combined (by superposition) with the primary noise p from the engine, together with any additional non-related noise n. The superposition of the various noise signals is shown schematically by summing junctions 10, 11.

The residual signal r is fed back to the LMS algorithm controller 7 together with the filtered-X signal w produced by model filter 8 (in position B2).

As previously explained, the model filter 8 is, in use, provided with filter weighting coefficients that model the transfer function between the actuator 3 and microphone 4, which is represented by block G in Figure 2. The weighting coefficients for filter 8 are determined in an initial set-up mode, in which the filter 8 is connected in position B1 in combination with an LMS algorithm controller 12.

During the set-up mode, the engine is switched off so that no primary signal p is produced. Instead, a reference signal q is artificially generated using a noise generator (not shown) to produce a secondary signal s that is detected by the microphone 4 and fed to a summing junction 13 so as to be combined with the output of the model filter 8 (in position B1). The resulting error signal e is fed to the algorithm controller 12 in combination with the signal q so that the controller 12 can adjust the weighting coefficients of filter 8 in a manner to minimise the error signal. In this way, the weighting coefficients for the filter 8 are adjusted such that the filter models the transfer function G.

In this prior art method, the signal q is selected to have a frequency which is a typical frequency of operation for the system and the weighting coefficients for the filter 8 are thereby selected to be appropriate for the selected frequency of signal q.

After the initial set up mode, the system is switched into a control mode in which the weighting factors for filter 8 determined during the set up mode are applied to the model filter 8 in position B2. With the engine running, primary noise is produced which is partially cancelled by the secondary noise s by superposition and the resulting residual signal r is fed to LMS algorithm controller 7 together with the filtered-X signal w, so as actively to control the weighting coefficients of control filter 6. In this way, the residual signal r is minimised thereby actively cancelling the primary noise p in an adaptive manner.

Although this system operates generally satisfactorily, a problem arises in that the transfer function G is only modelled for one frequency i.e. the frequency of signal q chosen during the set up mode. It however has now been found that the transfer function G varies in dependence upon engine speed and hence the frequency of signal q. The transfer function may also vary as a function of other operating conditions.

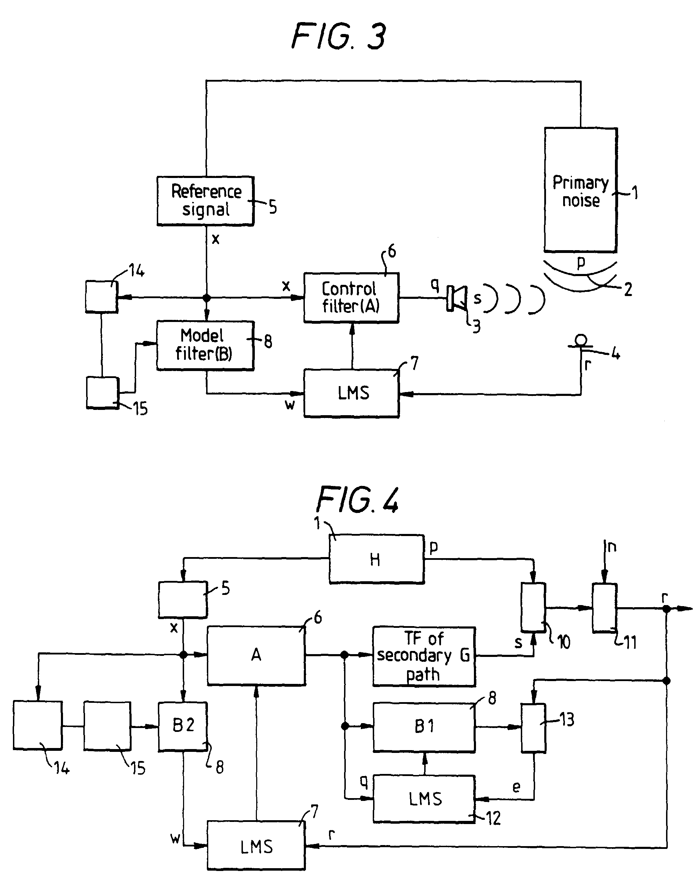

The present invention provides a solution to this problem. Referring now to Figures 3 and 4, an example of a system according to the invention is shown, and can be considered as a modification to the system described with reference to Figures 1 and 2 and similar component parts are marked with the same reference numbers.

Thus, referring to Figure 3, the apparatus according to the invention includes a model filter 8 which can be loaded with different sets of weighting characteristics depending on the frequency of the reference signal x. To this end, the system includes a frequency detector 14 for detecting the frequency of the reference signal x, and a store 15 containing a plurality of different sets of weighting factors which can be applied to the filter 8. In accordance with the invention, it has been appreciated that the transfer function G can vary as a function of frequency, and the set of weighting factors used to model the system is selected from the store 15 according to the actual frequency of the signal x.

Referring to Figure 4, during the set-up mode, the signal q is fed to the system at a plurality of different frequencies which span the expected range of operation of the system. For each frequency of the test signal q, the LMS algorithm controller is used to adjust the filter 8 in position B1 to obtain a set of weighting factors appropriate for the frequency concerned. Each set of weighting factors is transferred to the store 15.

In the control mode, the frequency detector 14 addresses the store 15 according to the frequency of the reference signal x so that the filter 8, in position B2, is provided with weighting factors that model the actual frequency of operation. Thus, as the engine changes speed, the weighting factors are changed according to the speed of operation. As a result, a much more accurate cancellation of noise occurs and the system can respond more rapidly to changes in engine speed. Thus, improved cancellation occurs during dynamic changes in engine speed than would occur with a conventional filtered-X system.

It will be appreciated that the invention could also be applied to changes in other operating conditions, for example external temperature or pressure and the values of the weighting factors would be derived by performing the set up mode over a range of values for the operating condition, so that sets of weighting factors could be obtained for the filter 8.

When the set-up mode is completed and the apparatus changes to the control mode, the control filter 6 can be started with the weighting factors set to zero so that an iterative convergence occurs by operation of the LMS algorithm 7. Alternatively, the filter 6 may be preprogrammed with a set of pre-stored weighting factors in order to speed up initial convergence.

Whilst the foregoing embodiment makes use of a set-up mode, it is alternatively possible to provide a parallel digital system identification process performed whilst the control filter is in operation, i.e. during the control mode, in order continuously to update the sets of stored weighting factors held in store 15.

Furthermore, whilst the convergence of the weighting factors is achieved by means of an LMS algorithm it will be appreciated that other algorithms could be used, e.g. Newton's method or the method of steepest descent.

Whilst the described apparatus is particularly suited to active noise cancellation, it could also be used for cancelling vibrations in mechanisms or structures or for cancelling electrical, optical thermal or fluid disturbances. Thus, whilst the actuator 3 is described as a loudspeaker, it could be any other suitable electro-dynamic hydraulic, pneumatic or piezo electric actuator. Similarly, the microphone 4 could be replaced by any suitable accelerometer velocimeter or other appropriate detector. The system described herein is a single channel system but it will be appreciated that multichannel systems could also be used.

## Claims

1. Apparatus for cancelling primary phenomena (p), such as noise, that are generally synchronous with a cyclic reference signal (x), comprising:
control filter means (6) for adaptively filtering the reference signal (x) to produce a secondary signal (q);
actuator means (3) responsive to the secondary signal (q) to produce secondary phenomena (s) for cancelling the primary phenomena (p);
error signal detecting means (4) for detecting the residual (r) of the primary and secondary phenomena;
model filter means (8) for filtering the reference signal (x) and having a filtering characteristic selected in dependence upon the transfer function (G) for said secondary phenomena from the actuator means through the detecting means, whereby to provide a filtered reference signal (w); and
means responsive (7) to said filtered reference signal and said detected residual for adaptively controlling said control filter means so as to tend to minimise said residual;
characterised by
the model filter means (8) having its filtering characteristics selectible for different values of an operating condition;
sensor means (14) for sensing the operating condition;
and selecting means (15) for selecting the filtering characteristic of the model filter means in dependence upon the sensed value of the operating condition.

2. Apparatus according to claim 1 wherein said selecting means (15) includes storage means that stores a plurality of sets of data concerning selectible filtering characteristics for the model filter means.

3. Apparatus according to claim 1 or 2 wherein said sensor means (14) comprises a frequency sensor for sensing the frequency of the reference signal.

4. Apparatus according to any preceding claim wherein said model filter means (8) comprises a transversal filter, and said selecting means (15) is operative to select a plurality of filter weights for the model filter means.

5. Apparatus according to claim 4 including adaptive controller means (12) for adjusting the filter weights during a set-up mode such as to provide a plurality of sets of filter weights corresponding to said transfer function for a plurality of different values of said operating condition respectively.

6. A method of cancelling primary phenomena (p), such as noise, that are generally synchronous with a cyclic reference signal (x) , comprising:
adaptively filtering the reference signal (x) with a control filter (6) to produce a secondary signal (q);
producing secondary phenomena (s) with actuator means (3) for cancelling the primary phenomena (p) in response to the secondary signal; detecting the residual (r) of the primary and secondary phenomena with detecting means (4);
filtering the reference signal with a model filter (8) having a filtering characteristic selected in dependence upon the transfer function (G) for the secondary phenomena from the actuator means through the detecting means whereby to provide a filtered reference signal (w); and
adaptively controlling the control filter (6) so as to tend to miminise the residual (r), in response to the detected residual and the filtered reference signal (w);
characterised by
sensing an operating condition; and selecting the filtering characteristic of the model filter means (8) in dependence upon the sensed operating condition.

7. A method according to claim 6 including during a set-up mode, selecting filtering characteristics for said model filter means (8) corresponding to the transfer function for a plurality of different values of said operating condition.

8. A method according to claim 6 or 7 wherein said operating condition comprises the frequency of the reference signal (x).

9. A method according to claim 6, 7 or 8 wherein said phenomena comprise accoustic noise.

10. A method according to claim 6, 7 or 8, wherein said phenomena comprise vibrations.

## Patentansprüche

1. Vorrichtung zum Aufheben von primären Erscheinungen (p) wie Geräuschen, die allgemein synchron zu einem zyklischen Referenzsignal (x) sind, enthaltend:
eine Steuerfiltereinrichtung (6) zum adaptiven Filtern des Referenzsignals (x), um ein sekundäres Signal (q) zu erzeugen;
eine Aktuatoreinrichtung (3), die auf das sekundäre Signal (q) reagiert, um sekundäre Erscheinungen (s) zum Aufheben der Primärerscheinungen (p) zu erzeugen;
eine Fehlersignal-Detektoreinrichtung (4) zum Nachweis des Restes (r) der primären und sekundären Erscheinungen;
eine Formfiltereinrichtung (8) zum Filtern des Referenzsignals (x), die eine Filtercharakteristik hat, die in Abhängigkeit von der Übertragungsfunktion (G) für die zweiten Erscheinungen von der Aktuatoreinrichtung durch die Detektoreinrichtung ausgewählt wird, um dadurch ein gefiltertes Referenzsignal (w) zu erzeugen; und
eine Einrichtung (7), die auf das gefilterte Referenzsignal und den nachgewiesenen Rest reagiert, zum adaptiven Steuern der Steuerfiltereinrichtung, um den Rest tendenziell zu minimieren;
dadurch gekennzeichnet, daß
die Filtercharakteristik der Formfiltereinrichtung (8) für verschiedene Werte einer Betriebsbedingung auswählbar ist; und durch
eine Sensoreinrichtung (14) zum Abfühlen der Betriebsbedingung; und eine Auswahleinrichtung (15) zum Auswählen der Filtercharakteristik der Formfiltereinrichtung in Abhängigkeit vom abgefühlten Wert der Betriebsbedingung.

2. Vorrichtung nach Anspruch 1, bei der die Auswahleinrichtung (15) eine Speichereinrichtung enthält, die eine Vielzahl von Datensätzen in bezug auf auswählbare Filtercharakteristiken für die Formfiltereinrichtung speichert.

3. Vorrichtung gemäß Anspruch 1 oder 2, bei der die Sensoreinrichtung (14) einen Frequenzsensor zum Abfühlen der Frequenz des Referenzsignals aufweist.

4. Vorrichtung nach einem der vorhergehenden Ansprüche, bei der die Formfiltereinrichtung (8) ein Transversalfilter aufweist und die Auswahleinrichtung (15) betriebsfähig ist, eine Vielzahl von Filtergewichten für die Formfiltereinrichtung auszuwählen.

5. Vorrichtung nach Anspruch 4, mit einer adaptiven Controller-Einrichtung (12) zum Einstellen der Filtergewichte während eines Einstellmodus, um eine Vielzahl von Sätzen von Filtergewichten entsprechend der Übertragungsfunktion für eine Vielzahl von verschiedenen Werten der jeweiligen Betriebsbedingung zu erzeugen.

6. Verfahren zum Aufheben von primären Erscheinungen (p) wie Geräuschen, die allgemein synchron zu einem zyklischen Referenzsignal (x) sind, enthaltend:
adaptives Filtern des Referenzsignals (x) mit einem Steuerfilter (6), um ein sekundäres Signal (q) zu erzeugen;
Erzeugen von sekundären Erscheinungen (s) mit einer Aktuatoreinrichtung (3), zum Aufheben der Primärerscheinungen (p) in Reaktion auf das sekundäre Signal, Nachweisen des Restes (r) der primären und sekundären Erscheinungen mit einer Detektoreinrichtung (4);
Filtern des Referenzsignals mit einem Formfilter (8), das eine Filtercharakteristik hat, die in Abhängigkeit von der Übertragungsfunktion (G) für die zweiten Erscheinungen von der Aktuatoreinrichtung durch die Detektoreinrichtung ausgewählt wird, um dadurch ein gefiltertes Referenzsignal (w) zu erzeugen; und
adaptives Steuern des Steuerfilters (6), um den Rest (r) tendenziell zu minimieren, in Reaktion auf den nachgewiesenen Rest und das gefilterte Referenzsignal (w);
gekennzeichnet durch
Abfühlen einer Betriebsbedingung; und Auswählen der Filtercharakteristik der Formfiltereinrichtung (8) in Abhängigkeit von der abgefühlten Betriebsbedingung.

7. Verfahren nach Anspruch 6, welches umfaßt, während eines Einstellmodus Filtercharakteristiken für die Formfiltereinrichtung (8) entsprechend der Übertragungsfunktion für eine Vielzahl von verschiedenen Werten der Betriebsbedingung auszuwählen.

8. Verfahren nach Anspruch 6 oder 7, bei dem die Betriebsbedingung die Frequenz des Referenzsignals (x) umfaßt.

9. Verfahren nach Anspruch 6, 7 oder 8, bei dem die Erscheinungen akustische Geräusche umfassen.

10. Verfahren nach Anspruch 6, 7 oder 8, bei dem die Erscheinungen Vibrationen umfassen.

## Revendications

1. Dispositif pour supprimer des phénomènes primaires (p), tels que du bruit, qui sont généralement synchrones avec un signal de référence cyclique (x), comprenant:
des moyens formant filtre de commande (6) pour filtrer de façon adaptative le signal de référence (x) pour produire un signal secondaire (q);
des moyens actionneurs (3) réagissant au signal secondaire (q) pour produire des phénomènes secondaires (s) afin de supprimer les phénomènes primaires (p) ;
des moyens de détection de signal d'erreur (4) pour détecter le résidu (r) des phénomènes primaires et secondaires;
des moyens formant filtre de modèles (8) pour filtrer le signal de référence (x) et ayant une caractéristique de filtrage sélectionnée selon la fonction de transfert (G) pour lesdits phénomènes secondaires provenant des moyens actionneurs par l'intermédiaire des moyens de détection, ce qui fournit un signal de référence filtré (w); et
des moyens (7) réagissant audit signal de référence filtré et audit résidu détecté pour commander de façon adaptative lesdits moyens formant filtre de commande de façon à tenter de minimiser ledit résidu;
caractérisé par
des moyens formant filtre de modèles (8) dont les caractéristiques de filtrage peuvent être sélectionnées pour différentes valeurs d'une condition de fonctionnement;
des moyens capteurs (14) pour capter la condition de fonctionnement;
et des moyens de sélection (15) pour sélectionner la caractéristique de filtrage des moyens formant filtre de modèles selon la valeur captée de la condition de fonctionnement.

2. Dispositif selon la revendication 1 dans lequel lesdits moyens de sélection (15) contiennent des moyens de mémorisation qui mémorisent une pluralité de groupes de données concernant les caractéristiques de filtrage pouvant être sélectionnées pour les moyens formant filtre de modèles.

3. Dispositif selon la revendication 1 ou 2 dans lequel lesdits moyens capteurs (14) comprennent un capteur de fréquence pour capter la fréquence du signal de référence.

4. Dispositif selon l'une quelconque des revendications précédentes dans lequel lesdits moyens formant filtre de modèles (8) comprennent un filtre transversal et lesdits moyens de sélection (15) ont pour fonction de sélectionner une pluralité de poids de filtrage pour les moyens formant filtre de modèles.

5. Dispositif selon la revendication 4 contenant des moyens formant contrôleur adaptatif (12) pour ajuster les poids de filtrage pendant un mode d'initialisation de manière à fournir une pluralité de groupes de poids de filtrage correspondant à ladite fonction de transfert pour une pluralité de valeurs différentes de ladite condition de fonctionnement respectivement.

6. Procédé de suppression de phénomènes primaires (p), tels que du bruit, qui sont généralement synchrones avec un signal de référence cyclique (x), comprenant les étapes consistant à:
filtrer de façon adaptative le signal de référence (x) avec un filtre de commande (6) pour produire un signal secondaire (q);
produire des phénomènes secondaires (s) avec les moyens actionneurs (3) pour supprimer les phénomènes primaires (p) en réaction au signal secondaire; détecter le résidu (r) des phénomènes primaires et secondaires avec les moyens de détection (4);
filtrer le signal de référence avec un filtre de modèles (8) ayant une caractéristique de filtrage sélectionnée selon la fonction de transfert (G) pour les phénomènes secondaires provenant des moyens actionneurs par l'intermédiaire des moyens de détection, ce qui fournit un signal de référence filtré (w); et
contrôler de façon adaptative le filtre de commande (6) de façon à tenter de minimiser le résidu (r), en réaction au résidu détecté et au signal de référence filtré (w);
caractérisé par les étapes consistant à
capter une condition de fonctionnement; et à sélectionner la caractéristique de filtrage des moyens formant filtre de modèles (8) selon la condition de fonctionnement captée.

7. Procédé selon la revendication 6 incluant, pendant un mode d'initialisation, l'étape consistant à sélectionner des caractéristiques de filtrage pour lesdits moyens formant filtre de modèles (8) correspondant à la fonction de transfert pour une pluralité de valeurs différentes de ladite condition de fonctionnement.

8. Procédé selon la revendication 6 ou 7 dans lequel ladite condition de fonctionnement comprend la fréquence du signal de référence (x).

9. Procédé selon la revendication 6, 7 ou 8 dans lequel lesdits phénomènes comprennent un bruit acoustique.

10. Procédé selon la revendication 6, 7 ou 8, dans lequel lesdits phénomènes comprennent des vibrations.
